(19) Europäisches Patentamt
European Patent Office
Office européen des brevets

(11) **EP 2 998 890 A1**

(12) **EUROPÄISCHE PATENTANMELDUNG**

(43) Veröffentlichungstag:
23.03.2016 Patentblatt 2016/12

(51) Int Cl.:
*G06F 17/50* (2006.01)

(21) Anmeldenummer: 14184941.4

(22) Anmeldetag: 16.09.2014

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(71) Anmelder:
• **Siemens Schweiz AG**
**8047 Zürich (CH)**
• **Siemens Aktiengesellschaft**
**80333 München (DE)**

(72) Erfinder:
• **Frey, Christian**
**6314 Unterägeri (CH)**
• **Klein, Wolfram**
**85579 Neubiberg (DE)**
• **Mayer, Hermann Georg**
**83209 Prien am Chiemsee (DE)**

(74) Vertreter: **Maier, Daniel Oliver**
**Siemens AG**
**Postfach 22 16 34**
**80506 München (DE)**

(54) **Verfahren zum rechnergestützten Entwurf eines Bauwerks**

(57) Die Erfindung betrifft ein Verfahren zum rechnergestützten Entwurf eines Bauwerks (1), das ein oder mehrere Stockwerke (101, 102, ..., 105) umfasst. Erfindungsgemäß wird ein Modell (MO) des Bauwerks, das eine Vielzahl von Bauwerksparametern (BP) (1) und die Personenbelegung des oder der Stockwerke (101, 102, ..., 105) umfasst, sowie Parameter (PA) zur Wegewahl der Personen beim Verlassen des Bauwerks (1) in einen Personenstromsimulator (PSM) eingelesen. Anschließend werden Evakuierungszeiten (ET) des Bauwerks (1) mittels des Personenstromsimulators (PSM) unter Variation der Werte einer oder mehrerer Bauwerksparameter (BP) aus dem Modell (MO) des Bauwerks (1) bestimmt und als optimierter oder optimierte Bauwerksparameterwerte (OP) werden die Werte des oder der Bauwerksparameter (BP) mit der geringsten Evakuierungszeit (ET) ermittelt.

FIG 2

EP 2 998 890 A1

**Beschreibung**

Die Erfindung betrifft ein Verfahren zum rechnergestützten Entwurf eines Bauwerks sowie ein entsprechendes Computerprogrammprodukt und ein entsprechendes Computerprogramm.

Herkömmlich werden im Rahmen des Entwurfs eines Bauwerks Parameter in Bezug auf Fluchtwege, wie z.B. Treppenhäuser, nach Planvorgaben bzw. entsprechenden gesetzlichen Richtlinien (z.B. Brandschutzrichtlinien) einmalig festgelegt. Dabei wird unter anderem nicht berücksichtigt, dass bei mehrgeschossigen Bauwerken die Gesamtanzahl der Personen auf dem Fluchtweg bei einer Evakuierung bzw. Entfluchtung von Stockwerk zu Stockwerk hin zu den Ausgängen zunimmt, was zu einer Verstopfung der Fluchtwege durch Überlastung führen kann.

Aufgabe der Erfindung ist es, ein Verfahren zum rechnergestützten Entwurf eines Bauwerks zu schaffen, mit dem optimierte Werte von Bauwerksparametern im Hinblick auf eine schnelle Personenevakuierung bestimmt werden.

Diese Aufgabe wird durch die unabhängigen Patentansprüche gelöst. Weiterbildungen der Erfindung sind in den abhängigen Ansprüchen definiert.

Das erfindungsgemäße Verfahren dient zum rechnergestützten Entwurf eines Bauwerks. Das Bauwerk umfasst einen oder mehrere Stockwerke. Im Falle von mehreren Stockwerken können Personen zwischen zumindest einem Teil der Stockwerke im Bauwerk wechseln. Der Begriff des Bauwerks ist hier und im Folgenden weit zu verstehen. Ein Bauwerk kann ein oberirdisches Gebäude (z.B. ein Haus) oder ein unterirdisches Gebäude (z.B. eine Bahnstation) oder eine Kombination aus oberirdischem und unterirdischem Gebäude darstellen.

Im Rahmen des erfindungsgemäßen Verfahrens werden in einem Schritt a) ein Modell des Bauwerks, das eine Vielzahl von Bauwerksparametern und die Personenbelegung des oder der Stockwerke umfasst, sowie Parameter zur Wegewahl der Personen beim Verlassen des Bauwerks in einen Personenstromsimulator eingelesen. Unter dem Modell des Bauwerks werden digitale Daten des Bauwerks verstanden. Die Bauwerksparameter beschreiben dabei den konstruktiven Aufbau des Bauwerks und repräsentieren somit seine Topologie. Die Personenbelegung gibt an, für wie viele Personen das entsprechende Stockwerk des Bauwerks ausgelegt ist. Als Modell des Bauwerks kann z.B. ein BIM-Modell (BIM = Building Information Modeling) verwendet werden. BIM-Modelle sind an sich aus dem Stand der Technik bekannt. Dabei werden alle relevanten Gebäudedaten digital gespeichert, kombiniert und vernetzt. Für das jeweilige BIM-Modell ist ein definiertes Format zur Speicherung der Gebäudedaten festgelegt.

Als Personenstromsimulator wird im erfindungsgemäßen Verfahren ein an sich bekannter Simulator verwendet, wobei ein Beispiel eines solchen Simulators in der detaillierten Beschreibung genannt ist. Dabei ist es auch bekannt, dass dem Personenstromsimulator geeignete Parameter zur Wegewahl der Personen beim Verlassen des Bauwerks zur Simulation einer Evakuierung bereitgestellt werden, so dass diese Parameter an dieser Stelle nicht näher dargelegt werden.

In einem Schritt b) des erfindungsgemäßen Verfahrens werden Evakuierungszeiten des Bauwerks mittels des Personenstromsimulators unter Variation der Werte einer oder mehrerer Bauwerksparameter aus dem Modell des Bauwerks bestimmt. Eine Evakuierungszeit ist dabei die Zeit, die zur Evakuierung aller Personen entsprechend der Personenbelegung aus dem Bauwerk benötigt wird. Im Rahmen von Schritt b) werden als optimierter oder optimierte Bauwerksparameterwerte die Werte des oder der mehreren Bauwerksparameter mit der geringsten Evakuierungszeit ermittelt. Selbstverständlich werden dabei an sich bekannte Nebenbedingungen an das Bauwerk, wie z.B. in Bezug auf die Dimensionen oder die Kosten des Bauwerks, berücksichtigt. Insbesondere können Nebenbedingungen durch Grenzen der zu variierenden Bauwerksparameterwerte vorgegeben werden. Zur Ermittlung der optimierten Bauwerksparameterwerte können an sich bekannte Optimierungsverfahren verwendet werden, wobei Beispiele solcher Verfahren in der detaillierten Beschreibung gegeben werden.

Das erfindungsgemäße Verfahren zeichnet sich dadurch aus, dass unter Verwendung eines Personenstromsimulators auf einfache Weise optimierte Bauwerksparameter im Hinblick auf eine schnelle Personenevakuierung ermittelt werden können. Vorzugsweise weist das Bauwerk mehrere Stockwerke auf und von dem oder den Bauwerksparametern, deren Werte in Schritt b) variiert werden, hängt die Menge an Personen ab, welche zwischen aufeinander folgenden Stockwerken in einer Zeitspanne wechseln können.

In einer besonders bevorzugten Ausführungsform umfassen der oder die Bauwerksparameter, deren Werte in Schritt b) variiert werden, Parameter von einer oder mehreren Treppen (vorzugsweise Fluchttreppen) im Bauwerk, wobei sich eine jeweilige Treppe zwischen zumindest einem Teil der Stockwerke des Bauwerks erstreckt. Der oder die Bauwerksparameter, deren Werte in Schritt b) variiert werden, betreffen vorzugsweise die Treppenbreite und/oder Stufenhöhe der jeweiligen Treppen und/oder die Anzahl von Treppen und/oder Parameter betreffend Treppenpodeste der jeweiligen Treppen im Bauwerk. Unter dem Begriff der Treppe ist hier und im Folgenden eine Treppe ohne automatische Beförderung zu verstehen, d.h. eine Treppe, welche durch Körperkraft einer Person überwunden werden muss.

Neben oder anstatt von Parametern in Bezug auf eine Treppe können die Bauwerksparameter, deren Werte in Schritt b) variiert werden, ggf. auch Parameter von einem oder mehreren automatischen Beförderungsmitteln zwischen Stockwerken im Bauwerk umfassen, wobei der oder die Bauwerksparameter insbesondere die Personenbeförderungsgeschwindigkeit und/oder die Personenbeförderungskapazität und/oder die Personenbeförderungsrichtung des oder der automatischen Beförderungsmittel und/oder die Anzahl der automatischen Beförderungsmittel umfasst. Bevorzugte Ausgestaltungen der automatischen Beförderungsmittel sind eine oder mehrere Aufzüge bzw. eine oder mehrere Rolltreppen im Bauwerk.

Im Falle, dass die zu optimierenden Bauwerksparameter die Treppenbreite zumindest einer Treppe im Bauwerk umfassen, ist die Treppenbreite vorzugsweise als eine Funktion derart gegeben, dass mit abnehmender Entfernung der vertikalen Positionen entlang der zumindest einen Treppe von einem vorbestimmten Bauwerksausgang die Treppenbreite monoton zunimmt (d.h. die Treppenbreite wird in Richtung der abnehmenden Entfernung niemals kleiner und in zumindest einem Teilabschnitt oder zumindest an einer Stelle entlang der Treppe größer). Dabei wird die Variation eines Bauwerksparameters in der Form der Treppenbreite in Schritt b) über die Variation von einem oder mehreren Funktionsparametern der Funktion durchgeführt. Mit dieser Variante der Erfindung wird geeignet berücksichtigt, dass bei einer Evakuierung eines Bauwerks die Anzahl der Personen auf der Treppe mit zunehmender Anzahl der Stockwerke hin zu einem Bauwerksausgang zunimmt.

In einer besonders bevorzugten Variante der soeben beschriebenen Ausführungsform wird die zumindest eine Treppe durch aufeinander folgende Treppenabschnitte zwischen benachbarten Stockwerken eines Stockwerkspaars beschrieben, wobei die Treppenbreite von einem Treppenabschnitt zu dem nächsten Treppenabschnitt in vertikaler Richtung hin zu dem vorbestimmten Bauwerksausgang monoton zunimmt, jedoch innerhalb eines Treppenabschnitts konstant bleibt. Vorzugsweise hängt die Treppenbreite eines jeweiligen Treppenabschnitts von einem Stockwerksindex des Stockwerkspaars ab, das der Treppenabschnitt verbindet. Mit dieser Variante der Erfindung wird auf einfache Weise eine Abhängigkeit der Treppenbreite eines Treppenabschnitts von seiner Nähe zu einem Bauwerksausgang modelliert. Je nach Ausführungsform kann die Abhängigkeit der Treppenbreite des jeweiligen Treppenabschnitts von dem Stockwerksindex unterschiedlich ausgestaltet sein. Zum Beispiel kann diese Abhängigkeit linear und/oder quadratisch und/oder kubisch und/oder exponentiell sein.

In einer weiteren, besonders bevorzugten Ausführungsform umfassen der oder die oben genannten Funktionsparameter der Funktion einen Parameter, der eine konstante Veränderung der Treppenbreite von einem Treppenabschnitt zum nächsten beschreibt. Auf diese Weise kann die optimale Treppenbreite im Hinblick auf die geringste Evakuierungszeit einfach und schnell berechnet werden.

In einer weiteren Ausführungsform des erfindungsgemäßen Verfahrens wird in Schritt b) die Nebenbedingung berücksichtigt, dass zumindest ein Teil der Bauwerksparameter nur vorbestimmte diskrete Werte annehmen darf. Insbesondere können nur bestimmte Abstufungen von Treppenbreiten zugelassen werden, die z.B. Standardtreppenmaße darstellen.

Neben dem oben beschriebenen Verfahren betrifft die Erfindung ferner ein Computerprogrammprodukt mit einem auf einem maschinenlesbaren Träger gespeicherten Programmcode zur Durchführung des erfindungsgemäßen Verfahrens bzw. einer oder mehrerer bevorzugter Varianten des erfindungsgemäßen Verfahrens, wenn der Programmcode auf einem Computer ausgeführt wird.

Darüber hinaus betrifft die Erfindung ein Computerprogramm mit einem Programmcode zur Durchführung des erfindungsgemäßen Verfahrens bzw. einer oder mehrerer bevorzugter Varianten des erfindungsgemäßen Verfahrens, wenn der Programmcode auf einem Computer ausgeführt wird.

Ausführungsbeispiele der Erfindung werden nachfolgend anhand der beigefügten Figuren detailliert beschrieben.

Es zeigen:

Fig. 1    eine schematische Darstellung eines Gebäudes, anhand dessen eine Ausführungsform des erfindungsgemäßen Verfahrens erläutert wird; und

Fig. 2    ein Ablaufdiagramm, welches die wesentlichen Schritte einer Ausführungsform des erfindungsgemäßen Verfahrens verdeutlicht.

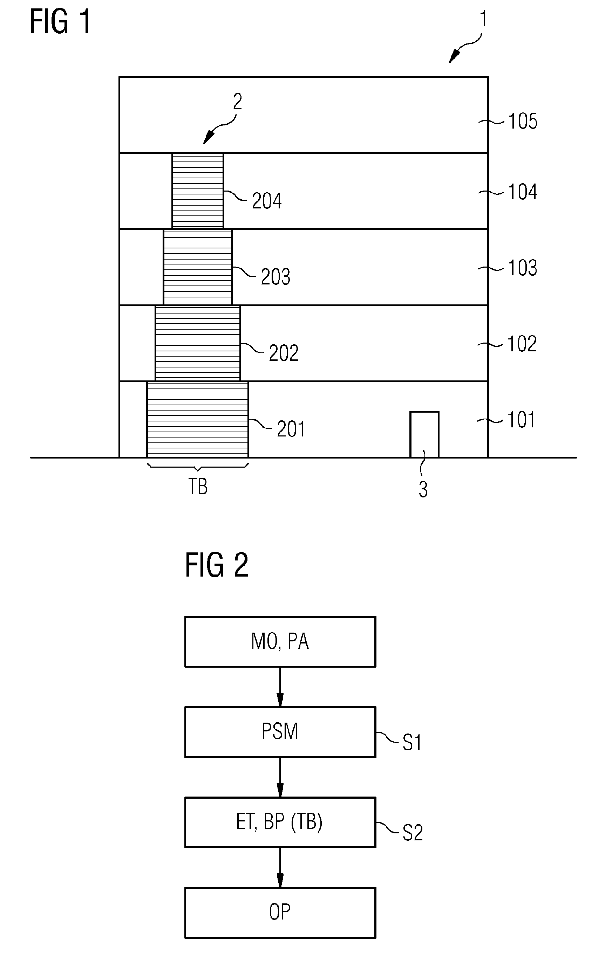

Im Folgenden wird ein Ausführungsbeispiel der Erfindung basierend auf der Berechnung einer optimalen Treppenbreite in einem oberirdischen Gebäude erläutert. Dieses Gebäude ist in Fig. 1 schematisch im Schnitt dargestellt und mit dem Bezugszeichen 1 bezeichnet. Das Gebäude umfasst fünf übereinander liegende Stockwerke 101, 102, 103, 104 und 105. Das Stockwerk 101 stellt das Erdgeschoss dar, das Stockwerk 102 den ersten Stock, das Stockwerk 103 den zweiten Stock usw. Im Erdgeschoss ist ein Gebäudeausgang 3 vorhanden. Die einzelnen Stockwerke 101 bis 105 sind über eine schematisch angedeutete Treppe 2 miteinander verbunden. Die Treppe umfasst einzelne Treppenabschnitte 201, 202, 203 und 204. Der Treppenabschnitt 201 verbindet das Stockwerk 101 mit dem Stockwerk 102, der Treppenabschnitt 202 das Stockwerk 102 mit dem Stockwerk 103, der Treppenabschnitt 203 das Stockwerk 103 mit dem Stockwerk 104 und der Treppenabschnitt 204 das Stockwerk 104 mit dem Stockwerk 105. Die (horizontale) Breite der Treppe ist in Fig. 1 mit TB angedeutet. Wie man erkennt, wird die Treppenbreite vom untersten Stockwerk 101 bis zu obersten Stockwerk 105 schrittweise abnimmt, jedoch innerhalb eines jeweiligen Treppenabschnitts konstant bleibt.

Im Rahmen der hier beschriebenen Ausführungsform wird für die einzelnen Treppenabschnitte der Treppe 2 eine optimierte Treppenbreite berechnet, welche zu der schnellstmöglichen Evakuierung des Gebäudes führt. Dabei fließt die Randbedingung ein, dass die Treppenbreite im Gebäude von oben nach unten zunimmt, wodurch der Tatsache Rechnung getragen wird, dass bei einer Evakuierung pro Stockwerk immer mehr Personen hinzukommen und somit die Personenaufnahmekapazität der Treppenabschnitte mit abnehmender Entfernung zum Ausgang 3 immer größer werden muss.

Die Daten des Gebäudes 1 liegen in der Form eines digitalen Gebäudemodells vor, welches die Topologie des Gebäudes basierend auf Bauwerksparametern beschreibt und die Personenbelegungen pro Stockwerk enthält. Die Bauwerksparameter geben die Dimensionen bzw. Abmessungen des Gebäudes mit entsprechenden Informationen über die Anzahl von Stockwerken sowie die Gebäudeeingänge bzw. Gebäudeausgänge wieder. Das digitale Gebäudemodell ist vorzugsweise in der Form eines an sich bekannten BIM-Modells gespeichert, in dem die Gebäudedaten in einem vorgegebenen Format hinterlegt sind. Aus dem BIM-Modell kann auch ein CAD-Modell (CAD = Computer Aided Design) des Gebäudes erstellt und geometrisch visualisiert werden.

Die wesentlichen Schritte der hier erläuterten Ausführungsform des erfindungsgemäßen Verfahrens werden anhand von Fig. 2 beschrieben. Ausgangspunkt des Verfahrens ist zum einen das gerade beschriebene digitale Gebäudemodell, welches in Fig. 2 mit MO bezeichnet ist. Ferner sind Parameter PA zur Wegewahl der Personen beim Verlassen des Gebäudes vorgegeben. Diese Parameter werden von der nachfolgend beschriebenen Evakuierungssimulation eines Personenstromsimulators benötigt. Die Verarbeitung solcher Parameter durch einen Personenstromsimulator ist an sich bekannt, weshalb diese Parameter nicht im Detail beschrieben werden. Die Parameter PA umfassen bestimmte Personenquellen und Personenziele bzw. die Wege der Personen von den Quellen zu den Zielen. Die Ziele betreffen entsprechende Ausgänge aus dem Gebäude, wobei in dem Gebäude 1 der Fig. 1 nur ein Ausgang 3 vorgesehen ist.

In einem Schritt S1 des Verfahrens der Fig. 2 werden durch einen Personenstromsimulator PSM das digitale Gebäudemodell MO sowie die soeben beschriebenen Parameter PA eingelesen. Es wird ein an sich aus dem Stand der Technik bekannter Personenstromsimulator eingesetzt. Zum Beispiel kann es sich um den Personenstromsimulator "PedGo" der TraffGo HT GmbH handeln.

Unter Verwendung des Personenstromsimulators PSM werden in einem Schritt S2 in an sich bekannter Weise mittels einer Evakuierungssimulation Evakuierungszeiten ET des Bauwerks (d.h. entsprechende Zeitspannen, bis alle Personen gemäß der Personenbelegung das Bauwerk verlassen haben) berechnet. Bei dieser Berechnung fließen das Modell MO und die Parameter PA ein. Erfindungsgemäß werden dabei bestimmte Bauwerksparameter BP, die in dem Modell MO enthalten sind, innerhalb bestimmter, durch die Gebäudetopologie vorgegebener Grenzen geeignet variiert. In der hier beschriebenen Ausführungsform wird die Treppenbreite TB der Treppe 2 aus Fig. 1 verändert. Dabei wird eine optimierte Treppenbreite TB ermittelt, für welche die Evakuierungssimulation des Personenstromsimulators PSM die geringste Evakuierungszeit liefert. Diese Treppenbreite wird als optimierter Bauwerksparameter OP gespeichert bzw. über eine geeignete Benutzerschnittstelle ausgegeben. Der Benutzer bekommt somit Aufschluss darüber, wie er im Rahmen des Gebäudeentwurfs die Treppenbreite TB in den einzelnen Stockwerken des Gebäudes der Fig. 1 optimal wählen sollte.

Die Berechnung der optimierten Treppenbreite gemäß Schritt S2 kann basierend auf einem beliebigen Optimierungsverfahren erfolgen. Insbesondere können aus dem Stand der Technik bekannte Optimierungsverfahren, wie z.B. das Simplex-Verfahren oder das Branch-and-Bound-Verfahren, genutzt werden. Nachfolgend werden zwei Varianten beschrieben, wie die Optimierung in Schritt S2 erfolgen kann.

Wie eingangs erwähnt, wird gemäß Fig. 1 davon ausgegangen, dass die Treppenbreite TB von oben nach unten zunimmt. In einer ersten Variante wird von einer linearen Zunahme der Treppenbreite pro Stockwerk ausgegangen. Dabei wird eine Verallgemeinerung des Gebäudes der Fig. 1 betrachtet, welches n Stockwerke aufweist. Der Index m beschreibt die Nummer des Stockwerks, zu dem der entsprechende Treppenabschnitt in vertikaler Richtung nach oben hinführt. Mit anderen Worten entspricht m=1 dem Treppenabschnitt 201, da dieser zum ersten Stockwerk führt, der Index m=2 dem Treppenabschnitt 202, da dieser zum zweiten Stockwerk führt, usw. Der letzte Index m=n beschreibt schließlich den Treppenabschnitt, der zum Stockwerk n führt, das in dem Beispiel der Fig. 1 das vierte Stockwerk ist. In der ersten Variante wird die Treppenbreite TB durch folgende, linear vom Stockwerksindex m abhängige Funktion beschrieben:

$$TB = T + x \cdot (n - m) \qquad (1)$$

Dabei entspricht T der minimalen Treppenbreite für den obersten Treppenabschnitt im Gebäude. Dieser Wert kann beispielsweise bei zwei Metern liegen. x ist ein Funktionsparameter der Funktion gemäß Gleichung (1), der die Zunahme der Treppenbreite der Treppenabschnitte von einem Stockwerk zum nächsten repräsentiert. Gemäß der ersten Variante wird in der obigen linearen Funktion der Funktionsparameter x im Rahmen eines Optimierungsverfahrens variiert, um denjenigen optimierten Funktionsparameter zu bestimmen, der zu der schnellsten, über den Personenstromsimulator berechneten Evakuierungszeit führt. Über die obige Funktion ist dann für jeden Treppenabschnitt die entsprechend zu wählende Treppenbreite festgelegt.

Die Optimierung im Rahmen der ersten Variante kann beispielsweise derart erfolgen, dass der Parameter x in Schritten von z.B. 0,1 m erhöht wird und eine Evakuierungssimulation mit dem Personenstromsimulator für jede Parametererhöhung durchgeführt wird. Hieraus ergeben sich jeweilige Evakuierungszeiten für das Gebäude mit dem zugeordneten Zuwachs x der Treppenbreite. Aus allen ermittelten Evakuierungszeiten wird die minimale Evakuierungszeit mit dem zugehörigen Zuwachs $x = x_{min}$ ausgewählt. Dieser Zuwachs wird dann über eine Benutzerschnittstelle ausgegeben.

Eine mögliche Verfeinerung des soeben beschriebenen Verfahren kann darin bestehen, dass nach der Bestimmung des Werts $x_{min}$ noch einmal feinere Werte aus einem Intervall um $x_{min}$ herum (z.B. $[x_{min} - 0{,}1; [x_{min} + 0{,}1])$ mit einer kleineren Schrittweite von z.B. 0,01 Metern ausgewählt werden und hieraus wiederum der Zuwachs mit der minimalen Evakuierungszeit mittels des Personenstromsimulators bestimmt und ausgegeben wird.

In einer zweiten Variante wird nicht mehr speziell von einer linearen Abhängigkeit der Treppenbreite von dem Stockwerkindex m ausgegangen. Vielmehr wird ein allgemeiner funktionaler Zusammenhang zwischen der Treppenbreite TB und dem Stockwerkindex m angenommen. Dieser Zusammenhang kann z.B. kubisch oder quadratisch sein oder durch eine exponentielle Funktion gegeben sein. Ein quadratischer Zusammenhang kann wie folgt beschrieben werden:

$$TB = a \cdot (n - m)^2 + b \cdot (n - m) + c \qquad (2)$$

Im Rahmen der Optimierung der Treppenbreite werden dann die Parameter a, b und c geeignet variiert, um die optimierte Treppenbreite im Hinblick auf die schnellstmögliche Evakuierungszeit zu bestimmen.

Für einen exponentiellen Zusammenhang ist die Treppenbreite zum Beispiel wie folgt gegeben:

$$TB = a \cdot \exp(n - m) \qquad (3)$$

Dabei wird wiederum der Parameter a geeignet variiert, um die Treppenbreite mit der minimalen Evakuierungszeit zu bestimmen.

In den o.g. Funktionen wurde von einem Zusammenhang zwischen der Treppenbreite und dem Stockwerksindex ausgegangen. Dieser Zusammenhang kann in einer abgewandelten Ausführungsform erweitert werden um eine Abhängigkeit von der erwarteten Personenzahl pro Stockwerksindex. Kommen in einem weiter unten liegenden Stockwerk nur sehr wenige oder auch sehr viele Personen zu der Treppe hinzu, muss hier die Treppenbreite nur sehr gering bzw. sehr deutlich erweitert werden. Diese Abhängigkeit kann ebenso in das Optimierungsverfahren mit einfließen.

Das erfindungsgemäße Verfahren wurde im Vorangegangenen basierend auf der Bestimmung einer Treppenbreite in einem oberirdischen Gebäude beschrieben. Nichtsdestotrotz kann das erfindungsgemäße Verfahren in gleicher Weise auch für andere Bauwerke, wie z.B. unterirdische Gebäude, insbesondere U-Bahn-Stationen, oder für Parkhäuser verwendet werden. Darüber hinaus können auch andere oder weitere optimierte Bauwerksparameter als die Treppenbreite einer Treppe ermittelt werden. Insbesondere können auch Parameter von Rolltreppen oder Aufzügen zwischen Stockwerken berücksichtigt werden, wie z.B. die Breite und die Anzahl von Rolltreppen oder die Laufgeschwindigkeit und die Laufrichtung von Rolltreppen bzw. entsprechende Aufzugsgeschwindigkeiten, Aufzugskapazitäten, Aufzugstransportrichtungen und dergleichen.

Die im Vorangegangenen beschriebenen Ausführungsformen der Erfindung weisen eine Reihe von Vorteilen auf. Insbesondere können optimierte Bauwerksparameter zur Erreichung einer sehr schnellen Evakuierungszeit basierend auf einer Optimierung unter Verwendung eines Personenstromsimulators ermittelt werden. Speziell kann über die Zunahme der Treppenbreite einer Fluchttreppe vermieden werden, dass es bei einer Notentfluchtung zu Verstopfungen kommt, welche bei gleichbleibend breiten Fluchtwegen in mehrstöckigen Gebäuden auftreten können. Ferner steht in den oberen Stockwerken aufgrund der kleineren Treppenbreite mehr Nutzfläche zur Verfügung, falls nicht über das Dach entfluchtet wird.

**Patentansprüche**

1. Verfahren zum rechnergestützten Entwurf eines Bauwerks (1), das ein oder mehrere Stockwerke (101, 102, ..., 105) umfasst, wobei:

   a) ein Modell (MO) des Bauwerks, das eine Vielzahl von Bauwerksparametern (BP) und die Personenbelegung des oder der Stockwerke (101, 102, ..., 105) umfasst, sowie Parameter (PA) zur Wegewahl der Personen beim Verlassen des Bauwerks (1) in einen Personenstromsimulator (PSM) eingelesen werden;
   b) Evakuierungszeiten (ET) des Bauwerks (1) mittels des Personenstromsimulators (PSM) unter Variation der Werte einer oder mehrerer Bauwerksparameter (BP) aus dem Modell (MO) des Bauwerks (1) bestimmt werden und als optimierter oder optimierte Bauwerksparameterwerte (OP) die Werte des oder der Bauwerksparameter (BP) mit der geringsten Evakuierungszeit (ET) ermittelt werden.

2. Verfahren nach Anspruch 1, **dadurch gekennzeichnet, dass** das Bauwerk (1) mehrere Stockwerke (101, 102, ..., 105) umfasst, wobei von dem oder den Bauwerksparametern (BP) die Menge an Personen abhängt, welche zwischen aufeinander folgenden Stockwerken (101, 102, ..., 105) in einer Zeitspanne wechseln können.

3. Verfahren nach Anspruch 1 oder 2, **dadurch gekennzeichnet, dass** der oder die Bauwerksparameter (BP) Parameter von einer oder mehreren Treppen (2) im Bauwerk (1) umfassen, wobei sich eine jeweilige Treppe (2) zwischen zumindest einem Teil der Stockwerke (101, 102, ..., 105) des Bauwerks (1) erstreckt.

4. Verfahren nach Anspruch 3, **dadurch gekennzeichnet, dass** das oder die Bauwerksparameter (BP) die Treppenbreite (TB) und/oder Stufenhöhe der jeweiligen Treppen (2) und/oder die Anzahl von Treppen und/oder Parameter betreffend Treppenpodeste der jeweiligen Treppen (2) im Bauwerk (1) umfassen.

5. Verfahren nach einem der vorhergehenden Ansprüche, **dadurch gekennzeichnet, dass** der oder die Bauwerksparameter (BP) Parameter von einem oder mehreren automatischen Beförderungsmitteln zwischen Stockwerken (101, 102, ..., 105) im Bauwerk (1) umfassen, wobei der oder die Bauwerksparameter (BP) insbesondere die Personenbeförderungsgeschwindigkeit und/oder die Personenbeförderungskapazität und/oder die Personenbeförderungsrichtung des oder der automatischen Beförderungsmittel und/oder die Anzahl der automatischen Beförderungsmittel umfasst.

6. Verfahren nach Anspruch 5, **dadurch gekennzeichnet, dass** das oder die automatischen Beförderungsmittel einen oder mehrere Aufzüge und/oder eine oder mehrere Rolltreppen im Bauwerk (1) umfassen.

7. Verfahren nach einem der vorhergehenden Ansprüche in Kombination mit Anspruch 4, **dadurch gekennzeichnet, dass** die Treppenbreite (TB) zumindest einer Treppe (2) im Bauwerk (1) als eine Funktion derart gegeben ist, dass mit abnehmender Entfernung der vertikalen Positionen entlang der zumindest einen Treppe (2) von einem vorbestimmten Bauwerksausgang (3) die Treppenbreite (TB) monoton zunimmt, wobei die Variation eines Bauwerksparameters (BP) in der Form der Treppenbreite (TB) in Schritt b) über die Variation von einem oder mehreren Funktionsparametern (FP) der Funktion durchgeführt wird.

8. Verfahren nach Anspruch 7, **dadurch gekennzeichnet, dass** die zumindest eine Treppe (2) durch aufeinander folgende Treppenabschnitte (201, 201, ..., 204) zwischen benachbarten Stockwerken (101, 102, ..., 105) eines Stockwerkpaars beschrieben wird, wobei die Treppenbreite (TB) von einem Treppenabschnitt (201, 201, ..., 204) zu dem nächsten Treppenabschnitt (201, 201, ..., 204) in vertikaler Richtung hin zu dem vorbestimmten Bauwerksausgang (3) monoton zunimmt, jedoch innerhalb eines Treppenabschnitts (201, 201, ..., 204) konstant bleibt.

9. Verfahren nach Anspruch 8, **dadurch gekennzeichnet, dass** die Treppenbreite (TB) eines jeweiligen Treppenabschnitts (201, 201, ..., 204) von einem Stockwerksindex des Stockwerkspaars abhängt, das der Treppenabschnitt (201, 201, ..., 204) verbindet.

10. Verfahren nach Anspruch 9, **dadurch gekennzeichnet, dass** die Abhängigkeit der Treppenbreite (TB) des jeweiligen Treppenabschnitts (201, 201, ..., 204) von dem Stockwerksindex linear und/oder quadratisch und/oder kubisch und/oder exponentiell ist.

11. Verfahren nach einem der Ansprüche 8 bis 10, **dadurch gekennzeichnet, dass** der oder die Funktionsparameter einen Parameter umfassen, der eine konstante Veränderung der Treppenbreite (TB) von einem Treppenabschnitt (201, 201, ..., 204) zum nächsten beschreibt.

**12.** Verfahren nach einem der vorhergehenden Ansprüche, **dadurch gekennzeichnet, dass** in Schritt b) die Nebenbedingung berücksichtigt wird, dass zumindest ein Teil der Bauwerksparameter (BP) nur vorbestimmte diskrete Werte annehmen darf.

**13.** Computerprogrammprodukt mit einem auf einem maschinenlesbaren Träger gespeicherten Programmcode zur Durchführung eines Verfahrens nach einem der vorhergehenden Ansprüche, wenn der Programmcode auf einem Computer ausgeführt wird.

**14.** Computerprogramm mit einem Programmcode zur Durchführung eines Verfahrens nach einem der Ansprüche 1 bis 12, wenn der Programmcode auf einem Computer ausgeführt wird.

FIG 1

FIG 2

Europäisches
Patentamt

European
Patent Office

Office européen
des brevets

**EUROPÄISCHER RECHERCHENBERICHT**

Nummer der Anmeldung

EP 14 18 4941

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | R.-P. Mundani ET AL: "Integrating evacuation planning into an octree-based CSCW framework for structural engineering", Proceedings CIB W78's 22nd International Conference on Information Technology in Construction, 21. Juni 2005 (2005-06-21), Seiten 1-6, XP055163799, ISBN: 978-3-86-005478-9 Gefunden im Internet: URL:http://itc.scix.net/data/works/att/w78-2005-A2-5-Mundani.pdf [gefunden am 2015-01-21] * das ganze Dokument * ----- | 1-14 | INV. G06F17/50 |
| Y | PELECHANO ET AL: "Evacuation simulation models: Challenges in modeling high rise building evacuation with cellular automata approaches", AUTOMATION IN CONSTRUCTION, ELSEVIER SCIENCE PUBLISHERS, AMSTERDAM, NL, Bd. 17, Nr. 4, 30. Januar 2008 (2008-01-30), Seiten 377-385, XP022440259, ISSN: 0926-5805, DOI: 10.1016/J.AUTCON.2007.06.005 * das ganze Dokument * ----- | 1-14 | RECHERCHIERTE SACHGEBIETE (IPC) G06F |

Der vorliegende Recherchenbericht wurde für alle Patentansprüche erstellt

| Recherchenort | Abschlußdatum der Recherche | Prüfer |
|---|---|---|
| München | 22. Januar 2015 | Lerbinger, Klaus |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

....................................................................................

& : Mitglied der gleichen Patentfamilie, übereinstimmendes Dokument

EPO FORM 1503 03.82 (P04C03)